(19) Europäisches Patentamt
European Patent Office
Office européen des brevets

(11) **EP 3 890 126 A1**

(12) **EUROPÄISCHE PATENTANMELDUNG**

(43) Veröffentlichungstag:
06.10.2021 Patentblatt 2021/40

(51) Int Cl.:
*H01S 5/12* (2021.01)     *H01S 5/042* (2006.01)
*H01S 5/20* (2006.01)     *H01S 5/10* (2021.01)
*H01S 5/125* (2006.01)     *H01S 5/343* (2006.01)

(21) Anmeldenummer: 21166314.1

(22) Anmeldetag: 31.03.2021

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**
Benannte Validierungsstaaten:
**KH MA MD TN**

(30) Priorität: 31.03.2020 DE 102020108941

(71) Anmelder: **Forschungsverbund Berlin E.V.**
**12489 Berlin (DE)**

(72) Erfinder:
• **Zeghuzi, Anissa**
**10245 Berlin (DE)**

• **Koester, Jan-Philipp**
**10409 Berlin (DE)**
• **Wenzel, Hans**
**12355 Berlin (DE)**
• **Christopher, Heike**
**12524 Berlin (DE)**
• **Knigge, Andrea**
**15711 Königs Wusterhausen (DE)**

(74) Vertreter: **Gulde & Partner**
**Patent- und Rechtsanwaltskanzlei mbB**
**Wallstraße 58/59**
**10179 Berlin (DE)**

(54) **DIODENLASER MIT VERRINGERTER STRAHLENDIVERGENZ**

(57) Die vorliegende Erfindung betrifft einen Diodenlaser mit verringerter Strahldivergenz. Die Idee der vorliegenden Erfindung ist es, durch eine gezielte Modulation des realen Brechungsindex des Diodenlasers eine Strahldivergenz im Fernfeld zu verringern. Hierzu wird ein Bereich des Diodenlasers, Injektionsgebiet genannt, mit unterschiedlichen Materialien mit unterschiedlichen Brechungsindexen strukturiert. Hierbei kann die Wahl des Materials den effektiven Brechungsindex an der jeweiligen longitudinal-lateralen Position beeinflussen.

Die Modulation des Brechungsindexes macht es möglich, eine Supermode anzuregen, deren Feld unter den Kontakten dieselbe Phase hat (In-Phase Mode) ist. Licht, welches unter den Bereichen eines niedrigeren Brechungsindexes propagiert, erhält nach einem Element-Durchgang der indexführenden Gräben einen Phasenversatz von $\pi$. Somit wird die In-phase Mode unterstützt und das Ausbilden der außer-Phase Mode verhindert. Folglich kann man auf diesem Wege im Gegensatz zu konventionellen Breitstreifen-Diodenlasern und insbesondere Streifenlasern das Laserfeld auch bei hohen Leistungen so stabilisieren, dass nur eine zentrale Strahlkeule im Fernfeld zurückbleibt.

Fig. 1

**Beschreibung**

Die vorliegende Erfindung betrifft einen Diodenlaser mit verringerter Strahldivergenz. Insbesondere betrifft die vorliegende Erfindung einen Diodenlaser mit verringerter Strahldivergenz mittels einer Modulation des realen Brechungsindexes des Diodenlasers.

*Stand der Technik*

Seit der Erfindung der Diodenlaser wurden verschiedene Konzepte vorgeschlagen, um die hohe Ausgangsleistung von Breitstreifenlasern mit der guten Strahlqualität von Rippenwellenleiter-Lasern zu vereinen. Die Grundidee aller dieser Ansätze ist das Unterdrücken ungewünschter lateraler Lasermoden.

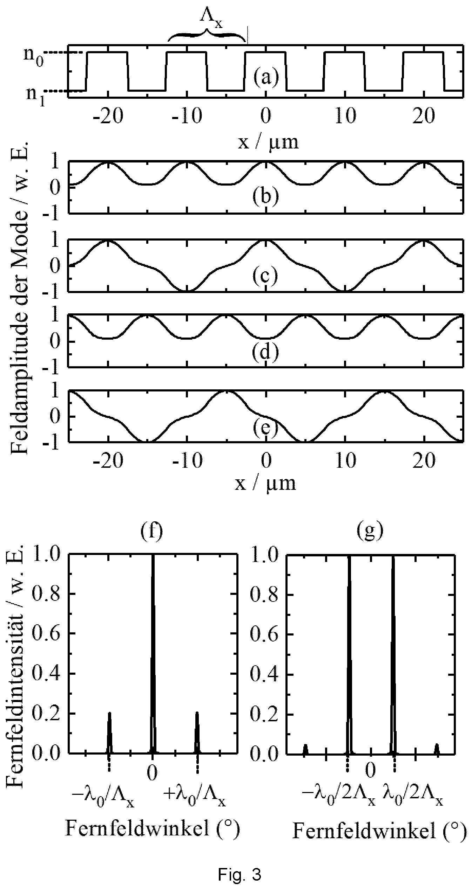

Ein Ansatz dies zu erreichen sind Streifenlaser. Sie kennzeichnen sich durch eine periodische Modulation des Kontaktes und Brechungsindexes in eine Richtung. Die Supermoden eines solchen Systems können je nachdem, ob die Intensitätsmaxima mit den Indexmaxima oder Indexminima übereinstimmen, in "evanescent-wave type" (Indexführung - siehe hierzu das laterale Profil der Feldamplitude in Abb. 3(b) und (c)) oder "leaky-wave type" (Anti-Indexführung - siehe hierzu das laterale Profil der Feldamplitude in Abb. 3(d) und (e)) eingeteilt werden. Stimmt die Phase aller Amplitudenpeaks überein, spricht man vom In-Phase Betrieb (siehe Abb. Abb. 3(b) und 3(d). Das resultierende Fernfeld besitzt eine beugungslimitierte Strahlkeule, sowie Seitenpeaks bei Fernfeldwinkeln von $\pm\varphi_0 = \lambda_0/\Lambda_x$ (siehe Abb. 3(f)), wobei $\lambda_0$ die Vakuumwellenlänge und $\Lambda_x$ die volle Periode der lateralen Indexmodulation ist. Besitzen die Amplituden-peaks einen $\pi$-Phasenversatz zueinander, spricht man vom Außer-Phase Betrieb (siehe Abb. Abb. 3(c) und 3(e). Das

$$\pm\varphi \approx \frac{\lambda_0}{2\Lambda_x}$$

entsprechende Fernfeld zeigt eine hohe Divergenz und besitzt zwei ausgeprägte Intensitätspeaks bei (siehe Abb. 3(g)), wobei $\lambda_0$ die Vakuumwellenlänge und $\Lambda_x$ die volle Periode der lateralen Indexmodulation ist.

Das Beugungsbild eines Gitters reproduziert sich bei paraxialer Propagation in einem bestimmten longitudinalen Abstand, Talbot-Länge genannt, wenn die Wellenlänge viel kleiner als der Abstand des Gitters ist. Des Weiteren wiederholt sich das Beugungsbild in einem Abstand der halben Talbot-Länge aber lateral um die halbe Länge der Gitterbreite verschoben.

Dieser Beugungseffekt kann in kontaktstrukturierten Lasern ausgenutzt werden, indem freilaufende Sektionen in die Kavität eingebracht werden, in denen es keine laterale Modulation des Gewinns oder realen Brechungsindexes gibt. Für diese als Talbot-Filter Sektionen bezeichneten Bereiche muss folgendes Verhältnis gelten:

$$\frac{2(\Lambda_x)^2 n_{\text{eff}}}{\lambda_0} = \Lambda_z, \qquad (1)$$

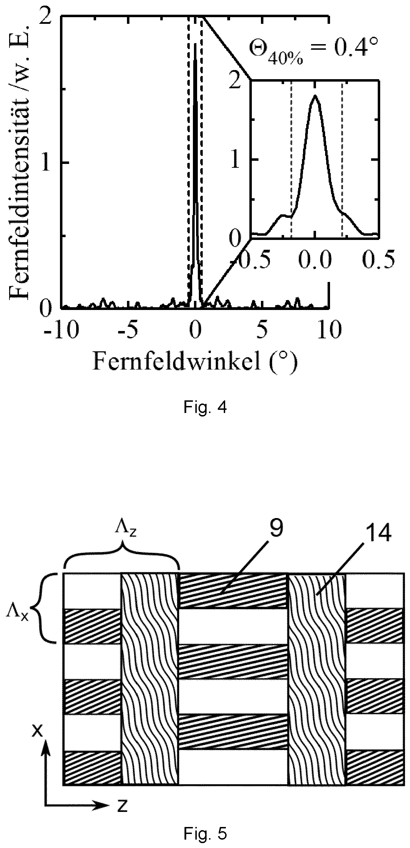

wobei $\Lambda_z = 2W_1$ die volle Periode in Propagationsrichtung ist, welche der Talbot-Länge entspricht, $W_1$ ist die Länge der freilaufenden Talbot-Filter Sektion,
$\Lambda_x = 2W_2$ die Periode in lateraler Richtung (siehe Abb 5), $W_2$ die laterale Breite der Kontaktstrukturierten Elemente, $n_{\text{eff}}$ ist der effektive Brechungsindex und $\lambda_0$ die Vakuum- Wellenlänge.

Laser, die den Talbot Effekt ausnutzen, um die In-Phase Mode zu unterstützen wurden schon früh in "P. D. V. Eijk, M. Reglat, G. Vassilieff, G. J. M. Krijnen, A. Driessen, and A. J. Mouthaan, "Analysis of the modal behavior of an antiguide diode laser array with Talbot filter," J. Light. Technol., vol. 9, no. 5, pp. 629--634, 1991" vorgestellt. Diese sind anders strukturiert als die erfindungsgemäße Vorrichtung zur Erzeugung von Laserstrahlung und beinhalten die oben beschriebenen freilaufenden Talbot-Filter Sektionen (siehe Abb. 5).

In "H. Yang, L. J. Mawst, M. Nesnidal, J. Lopez, A. Bhattacharya, and D. Botez, "10 W near-diffraction-limited peak pulsed power from Al-free phase-locked antiguided arrays," Electron. Lett., vol. 33, no. 2, pp. 136-137, 1997" wurden mit einem anti-Index geführten Laser, der einen Talbot-Filter nutzte, ein Fernfeld-Winkel mit einer vollen Halbwertsbreite von 0.62° mit einem Leistungsinhalt von 60% bei 10 W Ausgangsleistungen bei 15 A Pulsstrom erreicht.

Bei beiden genannten Arbeiten handelt es sich um Anti-Index geführte Laser. Hier stimmen die Intensitätsmaxima mit den Brechungsindex-Minima überein (siehe Abb. 3(d)) und die Anregung der In-Phase Supermode ist aufgrund der lateralen Gewinnverteilung leichter gegenüber Index-geführten Lasern. Jedoch zeichnen sich Anti-Index geführte Laser durch hohe Verluste aus und müssen in einem vergleichsweise aufwendigen Herstellungsprozess gewachsen werden, da hier eine Zwei-Schritt Epitaxie notwendig ist. Des Weiteren entstehen bei der Anregung der gewünschten In-Phase Mode wie oben schon erwähnt Seitenpeaks bei Fernfeldwinkeln von $\pm\varphi_0 = \lambda_0/\Lambda_x$ (siehe Abb. 3(f)), welche den Leistungsinhalt der zentralen Lobe beschränkt.

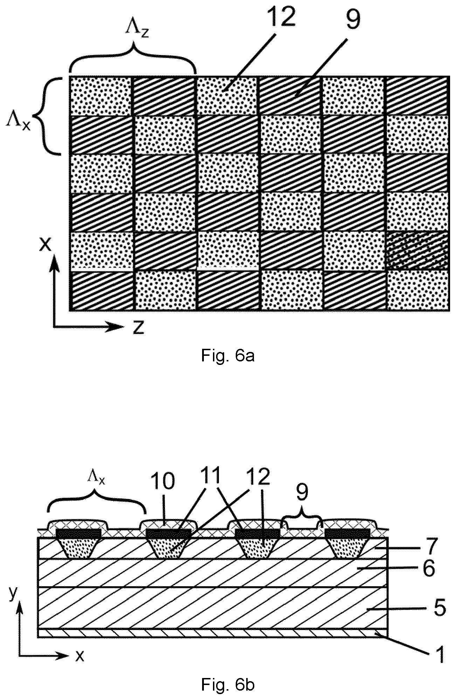

In "K. Staliunas, R. Herrero, and R. Vilaseca, "Subdiffraction and spatial filtering due to periodic spatial modulation of the gain-loss profile," Phys. Rev. A, vol. 80, no. 1, p. 013821, 2009" wurde gezeigt, dass eine longitudinal-laterale GewinnNerlust Modulation in der Art von Fig. 6 zu einem anisotropen Gewinn führt. In "M. Radziunas, M. Botey, R. Herrero, and K. Staliunas, "Intrinsic Beam Shaping Mechanism in Spatially Modulated Broad Area Semiconductor Amplifiers," Appl. Phys. Lett., vol. 103, no. 13, p. 132101, 2013" wurde durch Simulationen gezeigt, dass dieses Konzept für Verstärker zu einem schmalen Fernfeld führen kann, wobei die entstehenden Seitenpeaks unterdrückt werden. Als Anwendung für Laser war dieses Konzept bisher nicht erfolgreich, da durch räumliches Lochbrennen die außer-Phase Supermode angeregt wird, sodass zwei Intensitäts-Peaks im Fernfeld entstehen und die Strahlqualität schlecht ist (siehe Fig. 3g).

In DE 10 2016 113 071 A1 wird eine Halbleiterlaserdiode umfassend eine Halbleiterschichtenfolge mit einer aktiven Schicht offenbart, wobei die Halbleiterschichtenfolge eine Grabenstruktur mit zumindest einem Graben oder einer Mehrzahl von Gräben zumindest auf einer Seite lateral neben dem aktiven Bereich aufweist. Aus DE 10 2010 040 767 A1 ist ein Halbleiterbauelement mit einem durch seitliche Gräben ausgebildeten Rippenwellenleiter bekannt.

*Offenbarung der Erfindung*

Es ist daher eine Aufgabe der vorliegenden Erfindung, einen Diodenlaser anzugeben, die die vorgenannten Nachteile überwindet.

Diese Aufgaben werden erfindungsgemäß durch die Merkmale des unabhängigen Patentanspruchs 1 gelöst. Zweckmäßige Ausgestaltungen der Erfindung sind in den jeweiligen Unteransprüchen enthalten.

Gemäß einem Aspekt der vorliegenden Erfindung umfasst der erfindungsgemäße Diodenlaser erste n-leitend ausgebildete Funktionsschichten; eine aktive Schicht, die zur Erzeugung elektromagnetischer Strahlung geeignet ist und die auf den ersten Funktionsschichten angeordnet ist; zweite p-leitend ausgebildete Funktionsschichten, die auf der aktiven Schicht angeordnet sind; einen p-Kontaktbereich, wobei der p-Kontaktbereich zur Ausbildung einer Talbot-Filtersektion eine longitudinal-laterale Strukturierung im Bereich eines Injektionsgebiets umfasst, wobei durch die Strukturierung einzelne p-Kontakte ausgebildet werden; und mindestens eine Facette zur Auskopplung elektromagnetischer Strahlung entlang einer zweiten Achse, wobei die ersten Funktionsschichten, die aktive Schicht und die zweiten Funktionsschichten entlang einer dritten Achse gestapelt sind; wobei die longitudinal-laterale Strukturierung zwischen den durch die Strukturierung ausgebildeten einzelnen p-Kontakten des p-Kontaktbereichs indexführende Gräben mit einem niedrigeren Brechungsindex im Vergleich zu dem Brechungsindex der zweiten p-leitend ausgebildeten Funktionsschichten umfasst.

Die Idee der vorliegenden Erfindung ist es, durch eine gezielte Modulation des realen Brechungsindex des Diodenlasers eine Strahldivergenz im Fernfeld zu verringern. Hierzu wird ein Bereich des Diodenlasers, Injektionsgebiet genannt, mit unterschiedlichen Materialien mit unterschiedlichen Brechungsindexen strukturiert. Hierbei kann die Wahl des Materials den effektiven Brechungsindex an der jeweiligen longitudinal-lateralen Position beeinflussen.

Die Modulation des Brechungsindexes macht es möglich, eine Supermode anzuregen, deren Feld unter den Kontakten dieselbe Phase hat (In-Phase Mode) ist. Licht, welches unter den Bereichen eines niedrigeren Brechungsindexes propagiert, erhält nach einem Durchgang der indexführenden Gräben einen Phasenversatz von $\pi$. Somit wird die In-phase Mode unterstützt und das Ausbilden der außer-Phase Mode verhindert. Folglich kann man auf diesem Wege im Gegensatz zu konventionellen Breitstreifen-Diodenlasern und insbesondere Streifenlasern das Laserfeld auch bei hohen Leistungen so stabilisieren, dass nur eine zentrale Strahlkeule im Fernfeld zurückbleibt.

Da die Ladungsträgerdichte und Temperatur und somit die Brechungsindexverteilung auch im gepulsten Betrieb bei sehr hohen Strömen vom Operationspunkt des Lasers abhängt, muss die Tiefe der indexführenden Gräben mit einem niedrigeren Brechungsindex an den Laseroperationspunkt angepasst werden. Dabei muss folgende Phasenbedingung für den Operationspunkt erfüllt sein:

$$\Delta\varphi(x,z) = k_0 \Lambda_z/2 \cdot (n_0(x,z) - n_1(x,z)) = \pi,$$

wobei $n_0(x,z)$ und $n_1(x,z)$ die realen Brechungsindexänderungen jeweils unter den Bereichen des p-Kontaktgebiets und der indexführenden Gräben mit einem niedrigeren Brechungsindex sind.

Die erste Achse, die zweite Achse und die dritte Achse stehen alle senkrecht zueinander. Vorzugsweise wird die erste Achse auch laterale Achse oder laterale Richtung genannt. Vorzugsweise wird die zweite Achse auch longitudinale Achse, longitudinale Richtung oder Propagationsrichtung genannt. Vorzugsweise wird die dritte Achse auch vertikale Achse oder vertikale Richtung genannt.

Vorzugsweise umfassen die indexführenden Gräben erste indexführende Gräben und zweite indexführende Gräben, wobei die zweiten indexführenden Gräben die jeweiligen äußersten indexführenden Gräben in erster Richtung darstellen. Die ersten indexführenden Gräben dienen der Phasenanpassung der Laserstrahlung und die zweiten optionalen indexführenden Gräben stabilisieren das Laserfeld.

Vorzugsweise umfassen die ersten n-leitend ausgebildeten Funktionsschichten eine n-Mantelschicht und eine n-Wellenleiterschicht, bevorzugter bestehen die ersten n-leitend ausgebildeten Funktionsschichten aus genau einer n-Mantelschicht und genau einer n-Wellenleiterschicht. Vorzugsweise hat die n-Wellenleiterschicht eine Dicke in erster Richtung von zwischen 0.1 μm bis 6 μm, noch bevorzugter 1 μm bis 3 μm. Vorzugsweise hat die n-Mantelschicht eine Dicke in erster Richtung von zwischen 0.1 μm bis 6 μm, noch bevorzugter 1 μm bis 3 μm.

Vorzugsweise umfassen die zweiten p-leitend ausgebildeten Funktionsschichten eine p-Mantelschicht und eine p-Wellenleiterschicht. Vorzugsweise hat die p-Wellenleiterschicht eine Dicke in erster Richtung von zwischen 0.1 μm bis 6 μm, noch bevorzugter 0.1 μm bis 2 μm. Vorzugsweise hat die p-Mantelschicht eine Dicke in erster Richtung von zwischen 0.1 μm bis 6 μm, noch bevorzugter 0.1 μm bis 2 μm. Vorzugsweise umfasst die longitudinal-laterale Strukturierung mindestens 12 indexführenden Gräben mit einem niedrigeren Brechungsindex.

Vorzugsweise ist die longitudinal-laterale Strukturierung entlang der ersten Achse abwechselnd mit zueinander unterschiedlichen Brechungsindexen strukturiert.

Vorzugsweise ist die longitudinal-laterale Strukturierung entlang der zweiten Achse abwechselnd mit zueinander unterschiedlichen Brechungsindexen strukturiert.

Die abwechselnde Strukturierung verursacht die Modulation des Brechungsindexes des Diodenlasers. Die abwechselnde Strukturierung besteht aus den indexführenden Gräben mit einem niedrigeren Brechungsindex und Bereichen der zweiten p-leitend ausgebildeten Funktionsschichten.

Vorzugsweise ragen die indexführenden Gräben mit einem niedrigeren Brechungsindex entlang der dritten Achse in die p-Mantelschicht hinein oder durchdringen diese.

Vorzugsweise ragen die indexführenden Gräben mit einem niedrigeren Brechungsindex entlang der dritten Achse in die p-Wellenleiterschicht hinein.

Die Höhe der bis zur aktiven Zone zurückbleibenden Schichten, also die Tiefe der indexführenden Gräben mit einem niedrigeren Brechungsindex die in die p-Wellenleiterschicht und / oder die p-Wellenleiterschicht hineinragen, bestimmt die Höhe des effektiven Brechungsindex-Unterschieds zwischen den strukturierten p-Kontaktbereichen und der indexführenden Gräben mit einem niedrigeren Brechungsindex. Sie muss so angepasst sein, dass Licht, welches unter den Bereichen eines niedrigeren Brechungsindexes propagiert nach einem Durchgang der indexführenden Gräben einen Phasenversatz von π erhält.

Vorzugsweise umfasst die longitudinal-laterale Strukturierung entlang der ersten Achse mindestens 6 indexführenden Gräben mit einem niedrigeren Brechungsindex, noch bevorzugter mindestens 10. Je größer die Anzahl der indexführenden Gräben entlang der ersten Achse ist, desto geringer ist die Fernfeld-Divergenz entlang der ersten Achse.

Vorzugsweise umfasst die longitudinal-laterale Strukturierung entlang der zweiten Achse mindestens 2 indexführenden Gräben mit einem niedrigeren Brechungsindex, noch bevorzugter mindestens 4. Je größer die Anzahl der indexführenden Gräben entlang der zweiten Achse ist, desto besser wird Licht, welches bei höheren Abstrahlwinkeln propagiert und zu Seitenpeaks im Fernfeld führt, unterdrückt.

Vorzugsweise umfasst eine Rückfacette eine DBR-Sektion. Diese DBR-Sektion würde eine wellenlängenstabilisierende Wirkung haben.

Vorzugsweise ist der p-Kontaktbereich entsprechend Formel 1 strukturiert. Die halbe Periode in lateraler Richtung liegt vorzugsweise im Bereich des 3 bis 10-fachen der Vakuum-Wellenlänge, um lateralen Monomodenbetrieb zu gewährleisten. Die halbe Periode in Propagationsrichtung ergibt sich vorzugsweise entsprechend der Formel 1.

Die verschiedenen in dieser Anmeldung genannten Ausführungsformen und Aspekte der Erfindung sind, sofern im Einzelfall nicht anders ausgeführt, mit Vorteil miteinander kombinierbar.

*Kurzbeschreibung der Zeichnungen*

Die Erfindung wird nachfolgend in Ausführungsbeispielen anhand der zugehörigen Zeichnung erläutert. Es zeigen:

Fig. 1      ein Ausführungsbeispiel der erfindungsgemäßen Diodenlasers

Fig. 2a      eine Darstellung einer longitudinal-lateralen Strukturierung eines weiteren Ausführungsbeispiels des erfindungsgemäßen Diodenlasers,

Fig. 2b      eine Ladungsträgerdichte-Verteilung und Phase des vorwärtspropagierenden optischen Feldes an den in Fig. 2a ausgezeichneten Positionen,

Fig. 2c      ein lateral-vertikaler (x,y)-Querschnitt des erfindungsgemäßen Diodenlasers,

Fig. 2d    ein lateral-vertikaler (x, y)-Querschnitt eines weiteren Ausführungsbeispiels des erfindungsgemäßen Diodenlasers,

Fig. 3    ein Beispiel einer Modulation des Brechungsindexes in konventionellen Streifenlasern unter (a), und dazu (b): eine Feldamplitude (in willkürlichen Einheiten) der In-Phase Supermode bei einer Indexführung entsprechend der Brechungsindexvariation in (a), (c): eine Feldamplitude (in willkürlichen Einheiten) der Außer-Phase Supermode bei einer Indexführung entsprechend der Brechungsindexvariation in (a), (d): eine Feldamplitude (in willkürlichen Einheiten) der In-Phase Supermode bei einer Anti-Indexführung entsprechend der Brechungsindexvariation in (a), (e): eine Feldamplitude (in willkürlichen Einheiten) der Außer-Phase Supermode bei einer Anti-Indexführung entsprechend der Brechungsindexvariation in (a), (f): eine Fernfeldintensität einer In-Phase Supermode eines konventionellen Diodenlasers, (g): eine Fernfeldintensität einer Außer-Phase Supermode eines konventionellen Diodenlasers,

Fig. 4    eine Darstellung eines lateralen Fernfeldes eines Ausführungsbeispiels des erfindungsgemäßen Diodenlasers,

Fig. 5    eine Darstellung der longitudinal-lateralen Strukturierung eines Lasers mit konventioneller Talbot-Filter Sektion,

Fig. 6a    eine Darstellung einer longitudinal-lateralen GewinnNerlust Modulation eines konventionellen Diodenlasers,

Fig. 6b    eine Darstellung des lateral-vertikalen Querschnitts einer GewinnNerlust Modulation eines konventionellen Diodenlasers.

*Ausführliche Beschreibung der Zeichnungen*

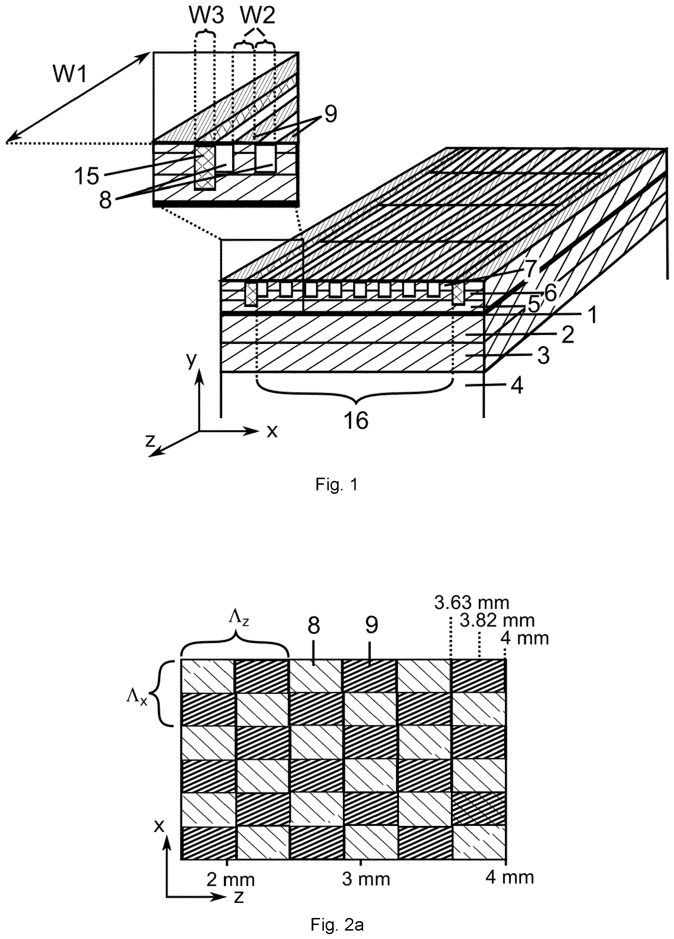

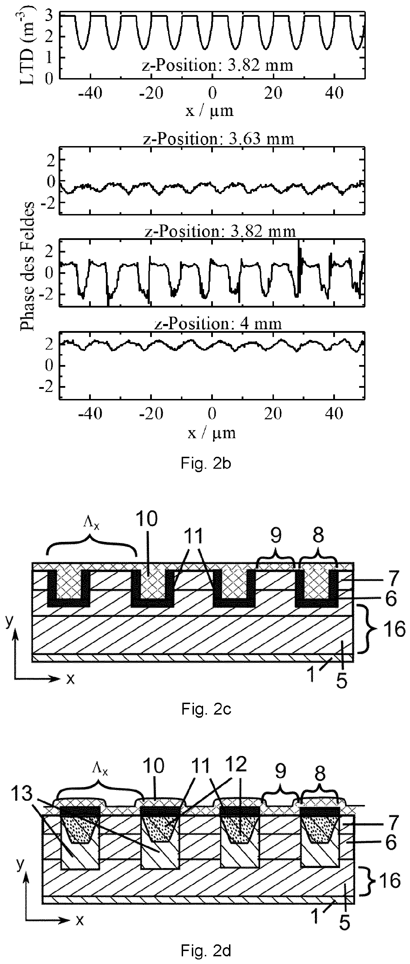

Figur 1 zeigt ein Ausführungsbeispiel des erfindungsgemäßen Diodenlasers vom Talbot-Typ mit longitudinal-lateraler Brechungsindex- und Gewinnmodulation. Die vertikale Schichtstruktur stimmt mit der einer konventionellen
Hochleistungslaserdiode überein. Diese besteht aus mindestens einer aktiven Schicht 1, die von p-Wellenleiter 5, p-Mantelschicht 6, n-Wellenleiter 2 und n-Mantelschicht 3 umgeben ist, welche wiederum auf dem Substrat 4 aufgebracht sind. Der Laser wird von einer Front- und Rückfacette begrenzt. Optional kann die Rückfacette durch eine wellenlängenstabilisierende DBR-Sektion ergänzt werden. Optional kann das laterale Injektionsgebiet 16 durch zweite indexführende Gräben 15 begrenzt werden, die durch die p-Mantelschicht 6 oder auch zusätzlich durch Teile der p-Wellenleiterschicht 5 geätzt werden, und das Laserfeld stabilisieren.
Der p-Kontaktbereich 9 ist dadurch gekennzeichnet, dass die Schichten in vertikaler Richtung unterhalb dieses Bereiches, also die p-Kontaktschicht 7, die p-Mantelschicht 6 und die p-Wellenleiterschicht 5 leitend sind. Die ersten indexführenden Gräben 8 hingegen leiten Strom nicht, sodass eine Strukturierung des p-Kontaktbereichs zu einer GewinnNerlust Modulation in der aktiven Schicht 1 führt. Um die Strukturierung des p-Kontaktbereichs deutlich zu machen, wurde die p-Metallisierung in der Darstellung in Figur 1 weggelassen. Ein lateral-vertikaler Querschnitt von Figur 1, der auch die p-Metallisierung beinhaltet ist in Figur 2c dargestellt.
Der p-Kontaktbereich 9 des Ausführungsbeispiels ist entsprechend der Formel 1 strukturiert.

$$\frac{2(\Lambda_{\mathrm{x}})^2 n_{\mathrm{eff}}}{\lambda_0} = \Lambda_{\mathrm{z}} \qquad (1)$$

Die halbe Periode in lateraler Richtung $W_2 = \Lambda_{\mathrm{x}}/2$ liegt bei 1 $\mu$m Vakuumwellenlänge bei 3 bis 10 $\mu$m. Die halbe Periode in Propagationsrichtung $W_1 = \Lambda_{\mathrm{z}}/2$ ergibt sich auch entsprechend der Formel 1 und liegt bei 1 $\mu$m Vakuumwellenlänge und $n_{\mathrm{eff}} \approx 3.3$ bei 100 $\mu$m bis 2000 $\mu$m.
Es wird zusätzlich zur longitudinal-lateralen Strukturierung des p-Kontaktbereichs 9 im Injektionsbereich 16 eine longitudinal-laterale Modulation des Brechungsindex eingeführt. Diese Modulation entsteht im Ausführungsbeispiel durch erste indexführende Gräben 8 mit einem Material eines niedrigeren Brechungsindexes im Vergleich zu dem Brechungsindex der p-Wellenleiterschicht 5 und der p-Mantelschicht 6. Die Anzahl der lateralen ersten indexführenden Gräben 8 mit einer Breite von $W_2$, die durch einen Abstand $W_2$ periodisch durch den p-Kontaktbereich getrennt sind, beträgt im Ausführungsbeispiel in Figur 1 acht. Die Anzahl der longitudinalen ersten indexführenden Gräben mit einer Länge von $W_1$, die durch einen Abstand $W_1$ periodisch durch den p-Kontaktbereich getrennt sind beträgt im Ausführungsbeispiel in Figur 1 zwei.

Diese ersten indexführenden Gräben 8 mit einem Material eines niedrigeren Brechungsindexes können durch Wegätzen der p-Mantelschicht 6 oder auch zusätzlich durch Wegätzen von Teilen der p-Wellenleiterschicht 5 erzeugt werden. In die geätzten Bereiche wird entweder eine Isolationsschicht 11 z.B. 100 nm SiN und darüber die p-Metallisierung 10 gegeben, wie in Figur 2c dargestellt oder aber die geätzten Bereiche werden mit einem Halbleitermaterial 13 überwachsen, welches einen niedrigeren Brechungsindex als die p-Wellenleiterschicht 5 und p-Mantelschicht 6 hat, wie in Figur 2d dargestellt. Da diese Bereiche leitend sind, müssen diese Bereiche eines anderen Brechungsindexes noch zusätzlich implantiert werden, damit die Strukturierung des p-Kontaktbereichs 9 auch zu einer Gewinn/Verlust-Modulation in der aktiven Zone 1 führt. Strom, der über die p-Metallisierung 10 in den p-Kontaktbereich 9 injiziert wird, spreizt in lateraler x-Richtung, sodass die Implantation mindestens die p-Kontaktschicht 7, besser aber zusätzlich die p-Mantelschicht durchdringen sollte.

Figur 2a zeigt eine Darstellung einer longitudinal-lateralen Strukturierung des erfindungsgemäßen Diodenlasers, der in Figur 1 dargestellt ist. Die longitudinal-laterale Strukturierung mit sich abwechselnden Bereichen von p-Kontaktgebiet 9 und ersten indexführenden Gräben 8, die zur Phasenanpassung genutzt werden, sind entsprechend Formel 1 strukturiert. Die Modulation des Brechungsindexes durch die ersten indexführenden Gräben 8 muss so gewählt werden, dass die Phasenbedingung,

$$\Delta\varphi(x,z) = \mathrm{k}_0\Lambda_z/2 \cdot (n_0(x,z) - n_1(x,z)) = \pi,$$

für den Operationspunkt erfüllt ist, wobei $n_0(x,z)$ und $n_1(x,z)$ die realen Brechungsindexänderungen jeweils unter den Bereichen des p-Kontaktgebiets 9 und der ersten indexführenden Gräben 8 sind. Ein beispielhaftes laterales Profil der Ladungsträgerdichte (LTD) an der z-Position 3.82 mm ist in Figur 3b oben dargestellt. In Figur 3b unten ist die Phase des vorwärts-propagierenden optischen Feldes an den in Fig. 2a ausgezeichneten Positionen gezeigt. Die Regionen einer niedrigen Ladungsträgerdichte entsprechen lateralen Regionen der Index-führenden Gräben. Es ist zu erkennen, dass die Phase des optischen Feldes welches in diesen Regionen propagiert bei der Propagation von der z- Position 3.63 mm zur z-Position 4 mm einen Phasenversatz von $\pi$ gegenüber dem Feld erhält welches in Regionen hoher Ladungsträgerdichte propagiert.

Figur 2c und 2d zeigen Ausführungsbeispiele der ersten indexführenden Gräben 8. In beidem Fällen wird Halbleitermaterial der p-Kontaktschicht 7, der p-Mantelschicht 6 und/oder der p-Wellenleiterschicht 5 weggeätzt. Im Fall von Figur 3c wird in die geätzten Bereiche eine Isolationsschicht 11 z.B. 100 nm SiN eingebracht, darüber liegt die p-Metallisierung 10. Im Falle von Figur 3d werden die geätzten Bereiche mit einem Halbleitermaterial 13 überwachsen, welches einen niedrigeren Brechungsindex als die p-Wellenleiterschicht 5 und p-Mantelschicht 6 hat. Nachteilig an diesem Prozess ist, dass eine aufwendige Zwei-Schritt-Epitaxie notwendig ist, weshalb das erstere Verfahren bevorzugt wird. In letzteren Fall ist das neu gewachsene Halbleitermaterial leitend und aus diesem Grund muss in diese Bereiche zusätzlich implantiert 12 werden, damit eine Gewinn/Verlust Modulation bis zur aktiven Zone gewährleistet ist.

In Figur 3a ist ein Beispiel einer Modulation des realen Brechungsindexes in konventionellen Streifenlasern dargestellt. Gleichzeitig entspricht dieses Profil auch der Modulation des realen Brechungsindexes im erfindungsgemäßen Laser an einer longitudinalen z-Position, wobei $n_0(x,z)$ und $n_1(x,z)$ die realen Brechungsindexänderungen jeweils unter den Bereichen des p-Kontaktgebiets 9 und der ersten indexführenden Gräben 8 sind. In Figur 3b bis 3e sind Feldamplituden erwähnenswerter Supermoden dieses konventionellen Streifenlasers dargestellt.

In Figur 3b und 3c sind Index-geführte Supermoden dargestellt, bei denen die Intensitätsmaxima, also das Betragsquadrat der dargestellten Feldamplituden, mit den Maxima der realen Brechungsindex-Modulation übereinstimmen.

In Figur 3d und 3e sind Anti-index-geführte Supermoden dargestellt, bei denen die Intensitätsmaxima mit den Minima der realen Brechungsindex-Modulation übereinstimmen. In Figur 3b und 3d sind die In-Phase Supermoden dargestellt, bei der die Phase benachbarten Intensitätspeaks übereinstimmt. In 3c und 3e sind die Außer-Phase Supermoden dargestellt, bei denen jeweils die Phase benachbarter Intensitätspeaks einen Phasenunterschied von $\pi$ zeigen. Das Fernfeld der In-Phase Supermoden aus Figur 3b und 3d ist in Figur 3f dargestellt. Es besitzt die erwünschte zentrale Strahlkeule, sowie Seitenpeaks bei Fernfeldwinkeln von $\pm \varphi_0 = \lambda_0/\Lambda_x$, wobei $\lambda_0$ die Vakuumwellenlänge und $\Lambda_x$ die volle Periode der lateralen Indexmodulation ist. Das Fernfeld der Außer-Phase Supermoden aus Figur 3c und 3e ist in Figur 3g dargestellt. Es zeigt eine hohe Divergenz und besitzt zwei ausprägte Intensitätspeaks bei $\pm\varphi \approx \lambda_0/2\lambda_x$.

Figur 4 zeigt die Fernfeldintensität einer konkreten Ausführungsform des erfindungsgemäßen Lasers in willkürlichen Einheiten. Die aktive Schicht 1 dieser Ausführungsform besteht aus einem 12 nm dicken InGaAs Quantengraben für Laserlicht-Emission bei einer Wellenlänge von 905 nm. Die aktive Schicht befindet sich zwischen 1,1 μm dicken n-Wellenleiterschichten und 0,2 μm dicken p-Wellenleiterschichten aus Al(0.40)Ga(0.60)As mit einer Dotierung von 1E17 cm$^{-3}$, begrenzt durch jeweils 2 μm dicke n-und p-Mantelschichten aus Al(0.45)Ga(0.55)As mit einer Dotierung von 1E18 cm$^{-3}$.

Es ist deutlich eine zentrale Strahlkeule zu erkennen, wobei die Seitenpeaks, die in Figur 3f erkennbar sind unterdrückt wurden. Die zentrale Strahlkeule hat einen Leistungsinhalt von 40% bei einem Fernfeldwinkel von $\theta_{40\%}$ = 0.4. In diesem konkreten Ausführungsbeispiel beträgt die volle laterale Periode $\Lambda_x$ = 6 $\mu m$ und die volle longitudinale Periode $\Lambda_z$ = 260 $\mu m$. Der durch Indexgräben herbeigeführte Brechungsindexunterschied beträgt $\Delta n_0$ = -5.5 · $10^{-3}$. Das Injektionsgebiet 16 hat eine Breite von 270 $\mu m$ und eine Länge von 3 mm. Es ist lateral von zweiten indexführenden Gräben 15 begrenzt, welche das Laserfeld zusätzlich stabilisieren. An der Rückfacette befindet sich ein wellenlängenstabilisierendes DBR Element mit einer Länge von 1 mm, sodass der gesamte Laser eine Länge von 4 mm hat.

Figur 5 zeigt die longitudinal-lateralen Strukturierung eines Lasers mit konventioneller Talbot-Filter Sektion. Er umfasst strukturierte p-Kontaktbereiche 9, die zu einer GewinnNerlust Modulation führen. Diese Regionen können theoretisch sowohl einen höheren als auch niedrigen realen Brechungsindex als die anliegenden Regionen haben, sodass die Supermode sowohl Index- als auch Anti-index-geführt sein kann. Bei den oben genannten Publikationen handelt es sich aber um Anti-index geführte Laser. Für die Länge dieser Sektionen in longitudinaler z-Richtung gibt es keine Design-spezifischen Einschränkungen. Der Laser hat zusätzlich konventionelle Talbot-Filter Sektionen mit einer Länge, die der halben Talbot-Länge $\Lambda_z$/2 entspricht. Die Sektionen sind longitudinal-lateral unstrukturiert und das optische Feld kann hier frei laufen.

In Figur 6a ist eine longitudinal-laterale GewinnNerlust Modulation nach Stand der Technik, ohne zusätzliche Modulation des realen Brechungsindex durch indexführende Gräben gezeigt und in Figur 6b der lateral-vertikalen Querschnitts einer solchen Modulation. Das longitudinal-laterale Gebiet besteht aus periodischen Abfolgen von p-Kontaktgebiet 9 und nichtleitenden implantierten Gebieten 12, wobei die volle Periode der lateralen Modulation $\Lambda_x$ und die volle Periode der longitudinalen Modulation $\Lambda_z$ der Formel 1 genügen. Damit Strom, der über die p-Metallisierung 10 in den p-Kontaktbereich 9 injiziert wird, nicht in lateraler x-Richtung spreizt muss die Implantation mindestens die p-Kontaktschicht 7, besser aber zusätzlich die p-Mantelschicht durchdringen. So kann eine GewinnNerlust Modulation bis zur aktiven Zone 1 gewährleistet sein.

**Bezugszeichenliste**

| | |
|---|---|
| 1 | Aktive Schicht |
| 2 | n-Wellenleiterschicht |
| 3 | n-Mantelschicht |
| 4 | Trägersubstrat |
| 5 | p-Wellenleiterschicht |
| 6 | p-Mantelschicht |
| 7 | p-Kontaktschicht |
| 8 | erste indexführende Gräben |
| 9 | p-Kontaktbereich |
| 10 | p-Metallisierung |
| 11 | Isolationsschicht |
| 12 | Implantierung |
| 13 | Halbleitermaterial eines niedrigeren Brechungsindexes als das Material der p-Schichten |
| 14 | freilaufende Talbot-Filter Sektion |
| 15 | (optionale) zweite indexführende Gräben |
| 16 | Injektionsgebiet |
| 17 | Restschichtdicke |
| W1 | Halbe Periode in Propagationsrichtung |
| W2 | Halbe Periode in lateraler Richtung |
| W3 | Breite der (optionalen) zweiten indexführenden Gräben |
| X | Erste Achse |
| Y | Dritte Achse |
| Z | Zweite Achse |

**Patentansprüche**

1. Diodenlaser, umfassend:

a) erste n-leitend ausgebildete Funktionsschichten (2, 3);
b) eine aktive Schicht (1), die zur Erzeugung elektromagnetischer Strahlung geeignet ist und die auf den ersten Funktionsschichten (2, 3) angeordnet ist;

c) zweite p-leitend ausgebildete Funktionsschichten (5, 6), die auf der aktiven Schicht (3) angeordnet sind;

d) einen p-Kontaktbereich (9), wobei der p-Kontaktbereich (9) zur Ausbildung einer Talbot-Filtersektion eine longitudinal-laterale Strukturierung im Bereich eines Injektionsgebiets (16) umfasst, wobei durch die Strukturierung einzelne p-Kontakte ausgebildet werden; und

e) mindestens eine Facette zur Auskopplung elektromagnetischer Strahlung entlang einer zweiten Achse (Z), wobei die ersten Funktionsschichten (2, 3), die aktive Schicht (1) und die zweiten Funktionsschichten (5, 6) entlang einer dritten Achse (Y) gestapelt sind;

**dadurch gekennzeichnet, dass**

f) die longitudinal-laterale Strukturierung zwischen den durch die Strukturierung ausgebildeten einzelnen p-Kontakten des p-Kontaktbereichs (9) indexführende Gräben mit einem niedrigeren Brechungsindex (8, 15) im Vergleich zu dem Brechungsindex der zweiten p-leitend ausgebildeten Funktionsschichten (5, 6) umfasst.

2.  Diodenlaser nach Anspruch 1, wobei die ersten n-leitend ausgebildeten Funktionsschichten (2, 3) eine n-Mantelschicht (3) und eine n-Wellenleiterschicht (2) umfassen.

3.  Diodenlaser nach einem der vorhergehenden Ansprüche, wobei die zweiten p-leitend ausgebildete Funktionsschichten (5, 6) eine p-Wellenleiterschicht (5) und eine p-Mantelschicht (6) umfassen.

4.  Diodenlaser nach einem der vorhergehenden Ansprüche, wobei die longitudinal-lateralen Strukturierung entlang einer ersten Achse (X) abwechselnd mit zueinander unterschiedlichen Brechungsindexen strukturiert ist.

5.  Diodenlaser nach einem der vorhergehenden Ansprüche, wobei die longitudinal-lateralen Strukturierung entlang der zweiten Achse (Z) abwechselnd mit zueinander unterschiedlichen Brechungsindexen strukturiert ist.

6.  Diodenlaser nach einem der vorhergehenden Ansprüche, wobei die indexführenden Gräben (8, 15) entlang der dritten Achse (Y) in die p-Mantelschicht (6) hineinragen oder diese durchdringen.

7.  Diodenlaser nach Anspruch 6, wobei die indexführenden Gräben (8, 15) entlang der dritten Achse (Y) in die p-Wellenleiterschicht (5) hineinragen.

8.  Diodenlaser nach einem der vorhergehenden Ansprüche, wobei die longitudinal-lateralen Strukturierung entlang der ersten Achse (X) mindestens sechs der indexführenden Gräben (8, 15) umfasst.

9.  Diodenlaser nach einem der vorhergehenden Ansprüche, wobei die longitudinal-lateralen Strukturierung entlang der zweiten Achse (Z) mindestens zwei der indexführenden Gräben (8, 15) umfasst.

10. Diodenlaser nach einem der vorhergehenden Ansprüche, wobei die indexführenden Gräben (8, 15) entlang der ersten Achse (X) erste indexführende Gräben (8) und zweiten indexführende Gräben (15) umfasst, wobei die zweiten indexführenden Gräben (15) entlang der ersten Achse (X) die jeweiligen äußersten indexführenden Gräben (15) darstellen.

Fig. 1

Fig. 2a

Fig. 2b

Fig. 2c

Fig. 2d

Fig. 3

$\Theta_{40\%} = 0.4°$

Fig. 4

$\Lambda_z$

9

14

$\Lambda_x$

x

z

Fig. 5

Fig. 6a

Fig. 6b

**Europäisches Patentamt**
**European Patent Office**
**Office européen des brevets**

# EUROPÄISCHER RECHERCHENBERICHT

Nummer der Anmeldung

EP 21 16 6314

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2009/268761 A1 (RICE ROBERT REX [US] ET AL) 29. Oktober 2009 (2009-10-29) | 1-9 | INV.<br>H01S5/12 |
| Y | * Absätze [0030] - [0050]; Abbildungen 1-11 * | 5,9,10 | H01S5/042<br>H01S5/20 |
| | ----- | | |
| X | US 5 442 650 A (MACOMBER STEVEN H [US]) 15. August 1995 (1995-08-15) | 1-3,5-7 | ADD.<br>H01S5/10 |
| Y | * Spalte 3, Zeile 16 - Spalte 6, Zeile 43; Abbildungen 1,2,10 * | 4,5,8-10 | H01S5/125<br>H01S5/343 |
| | ----- | | |
| Y | RADZIUNAS MINDAUGAS ET AL: "Intrinsic beam shaping mechanism in spatially modulated broad area semiconductor amplifiers", APPLIED PHYSICS LETTERS, Bd. 103, Nr. 13, 23. September 2013 (2013-09-23), Seite 132101, XP55828243, US ISSN: 0003-6951, DOI: 10.1063/1.4821251 * Seiten 132101-1, linke Spalte, Absatz 2 - Seiten 132101-4, linke Spalte, Absatz 1; Abbildungen 1-4 * | 4,5,8,9 | |
| | ----- | | |
| Y | DE 10 2010 040767 A1 (FORSCHUNGSVERBUND BERLIN EV [DE]) 15. März 2012 (2012-03-15) * Absätze [0036] - [0040], [0045] - [0047]; Abbildungen 6-8 * | 10 | |
| | ----- | | |

RECHERCHIERTE SACHGEBIETE (IPC)

H01S

Der vorliegende Recherchenbericht wurde für alle Patentansprüche erstellt

| Recherchenort | Abschlußdatum der Recherche | Prüfer |
|---|---|---|
| München | 29. Juli 2021 | Laenen, Robert |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

EPO FORM 1503 03.82 (P04C03)

## ANHANG ZUM EUROPÄISCHEN RECHERCHENBERICHT
## ÜBER DIE EUROPÄISCHE PATENTANMELDUNG NR.

EP 21 16 6314

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

29-07-2021

| Im Recherchenbericht angeführtes Patentdokument | Datum der Veröffentlichung | Mitglied(er) der Patentfamilie | Datum der Veröffentlichung |
|---|---|---|---|
| US 2009268761 A1 | 29-10-2009 | US 2009268761 A1<br>US 2016254649 A1<br>US 2017187167 A1 | 29-10-2009<br>01-09-2016<br>29-06-2017 |
| US 5442650 A | 15-08-1995 | KEINE | |
| DE 102010040767 A1 | 15-03-2012 | DE 102010040767 A1<br>EP 2617110 A2<br>US 2013208748 A1<br>WO 2012034972 A2 | 15-03-2012<br>24-07-2013<br>15-08-2013<br>22-03-2012 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102016113071 A1

- DE 102010040767 A1

**In der Beschreibung aufgeführte Nicht-Patentliteratur**

- **P. D. V. EIJK ; M. REGLAT ; G. VASSILIEFF ; G. J. M. KRIJNEN ; A. DRIESSEN ; A. J. MOUTHAAN.** Analysis of the modal behavior of an antiguide diode laser array with Talbot filter. *J. Light. Technol.,* 1991, vol. 9 (5), 629-634
- **H. YANG ; L. J. MAWST ; M. NESNIDAL ; J. LOPEZ ; A. BHATTACHARYA ; D. BOTEZ.** 10 W near-diffraction-limited peak pulsed power from Al-free phase-locked antiguided arrays. *Electron. Lett.,* 1997, vol. 33 (2), 136-137

- **K. STALIUNAS ; R. HERRERO ; R. VILASECA.** Subdiffraction and spatial filtering due to periodic spatial modulation of the gain-loss profile. *Phys. Rev. A,* 2009, vol. 80 (1), 013821
- **M. RADZIUNAS ; M. BOTEY ; R. HERRERO ; K. STALIUNAS.** Intrinsic Beam Shaping Mechanism in Spatially Modulated Broad Area Semiconductor Amplifiers. *Appl. Phys. Lett.,* 2013, vol. 103 (13), 132101